# EUROPÄISCHE PATENTSCHRIFT

(11) **EP 3 785 500 B1**
(45) Veröffentlichungstag und Bekanntmachung des Hinweises auf die Patenterteilung: **21.05.2025**
(21) Anmeldenummer: 19731218.4
(22) Anmeldetag: 12.06.2019
(51) Int. Cl.: H05K 7/14, H01M 10/42, H02M 7/00

(54) **ENERGIESPEICHERVORRICHTUNG**
ENERGY STORAGE DEVICE
DISPOSITIF ACCUMULATEUR D'ÉNERGIE

(30) Priorität: 15.06.2018 DE 102018114462
(43) Veröffentlichungstag der Anmeldung: 03.03.2021
(73) Patentinhaber: Liebherr-Electronics and Drives GmbH, 88131 Lindau (DE)
(72) Erfinder: WELSER, Sven, 88437 Äpfingen (DE); WANNER, Harald, 88448 Attenweiler (DE); RIED, Daniel, 88433 Schemmerhofen (DE); SCHULER, Michael, 88400 Biberach (DE); EICHLER, Markus, 79761 Waldshut (DE); SIGG, Dietmar, 88499 Riedlingen (DE)
(74) Vertreter: Thoma, Michael
(86) Internationale Anmeldenummer: PCT/EP2019/065391
(87) Internationale Veröffentlichungsnummer: WO 2019/238778

(56) Entgegenhaltungen:
- EP-A1- 2 693 514
- WO-A1-2018/083332
- JP-A- 2012 084 486
- US-A1- 2015 343 970
- US-A1- 2017 294 633

## Beschreibung

Die vorliegende Erfindung betrifft eine Energiespeichervorrichtung, mit einem Schaltschrankgehäuse, in dem mehrere Aufnahmeplätze vorgesehen sind, in denen zumindest eine Steuervorrichtung und eine variable Anzahl von elektrischen Speicherblöcken austauschbar aufgenommen sind, wobei die Speicherblöcke wahlweise seriell oder parallel zueinander verschaltbar und über einen Stromsteller mit Leistungsanschlüssen verbunden sind.

Energiespeichervorrichtungen der genannten Art sind beispielsweise aus der Schrift EP 2 693 514 A1 bekannt. Ähnliche Energiespeichervorrichtungen zeigen auch die Schriften JP 2012 084 486 A, WO 2018/083332 A1, US 2017/294366 A1 und US 2015/343970 A1.

Solche in Schaltschränke verbauten Energiespeichervorrichtungen sind aus der Praxis bereits bekannt und werden für verschiedene Anwendungen eingesetzt, in denen häufig auch für andere Komponenten der Einbauumgebung Schaltschränke verwendet werden. Insbesondere können die Energiespeichervorrichtungen für elektrische Antriebssysteme eingesetzt werden, die im Betrieb zyklisch Energie benötigen und dann im Generatorbetrieb wieder abgeben, sodass es sinnvoll ist die wieder abgegebene elektrische Energie zwischenzuspeichern. Für solche elektrischen Antriebssysteme sind häufig bereits Schaltschränke vorhanden, in denen eine Systemsteuerung und für den Netzbetrieb benötigte Steuerungskomponenten wie die Leistungselektronik einschließlich Frequenzumrichter, Sicherungen und ähnliche elektrische und elektronische Komponenten untergebracht sind. Insofern ist es für die unterstützend eingesetzten Energiespeichervorrichtungen günstig, in ähnlichen Schaltschränken untergebracht zu werden, um beispielsweise mit der übergeordneten Steuerung oder der Leistungselektronik für den Netzbetrieb in einem benachbarten Schaltschrank in einfacher Weise verbunden werden zu können und leichten Zugriff auf die Energiespeichervorrichtung zu geben.

Zur Einsparung von Energie werden immer mehr Antriebe elektrifiziert, die bislang mechanisch oder hydraulisch betrieben wurden, um den besseren Wirkungsgrad von Elektromotoren ausnutzen zu können. Dabei ist es insbesondere bei Anwendungen mit zyklisch wiederkehrenden Beschleunigungs- und Bremsphasen bzw. Bergauf- und Bergabfahrten sinnvoll, eine Energiespeichervorrichtung in das Antriebssystem zu integrieren bzw. daran anzuschließen, um bei Beschleunigungs- bzw. Bergaufphasen Energie bereitzustellen und bei Brems- bzw. Bergabphasen freigesetzte Energie rückzuspeisen und in dem zumindest einen Speicherblock zu speichern, wozu sich Kondensatoren, insbesondere Doppelschichtkondensatoren, aber andere Batteriesysteme oder Akkumulatoren eignen. Dabei fallen je nach Antriebssystem zum Teil beträchtliche Energiemengen an, die es bereitzustellen und zwischenzuspeichern gilt, sodass herkömmliche Energiespeicher schnell an ihre Grenzen stoßen bzw. es einer intelligenten Steuerung bedarf, um den Anforderungen gerecht zu werden.

Um die von dem zumindest einen Speicherblock bereitgestellte Spannung bzw. den abgegebenen Strom an das jeweilige Antriebssystem und dessen Spannungs- und/oder Strombedarf anzupassen und/oder umgekehrt den vom Antriebssystem rückgespeisten Strom an die Gegebenheiten des internen Spannungskreises des Speicherblocks anzupassen, kann die Energiespeichervorrichtung zumindest einen Stromrichter-Baustein aufweisen, um den bereitgestellten oder eingespeisten Strom hinsichtlich charakteristischer Parameter wie Spannung und/oder Frequenz in der benötigten Weise anzupassen.

Die Verwendung eines Schaltschrankgehäuses mit diversen Aufnahmeplätzen erlaubt es dabei in einfacher Weise, die jeweilige Energiespeichervorrichtung an das jeweilige Antriebssystem anzupassen. Insbesondere können je nach benötigtem Leistungs- und Spannungsniveau unterschiedlich ausgebildete und unterschiedlich viele Speicherblöcke in dem Schaltschrank untergebracht werden. Während für ein kleineres Antriebssystem beispielsweise ein einziger Speicherblock im Schaltschrank ausreichend sein kann, können für eine andere Anwendung in demselben Schaltschrank zwei, drei oder auch vier und fünf Speicherblöcke untergebracht werden. Dabei können auch für verschiedene Betriebsarten verschiedene Speicherblocktypen untergebracht bzw. gegeneinander ausgetauscht werden. Gilt es beispielsweise, große Strommengen kurzfristig zwischenzuspeichern, beispielsweise aufgrund eines in kurzen Zyklen erfolgenden Bergauf- und Bergabbetriebs, können Kondensatorzellen, insbesondere Speicherblöcke mit Doppelschichtkondensatoren vorteilhaft sein. Wird die Energiespeichervorrichtung indes für einen gleichmäßigeren Betrieb eingesetzt, in dem nur bisweilen - beispielsweise für Anlaufphasen - ein zusätzlicher Energieschub oder auch nur eine Notfallversorgung benötigt wird, können Batteriezellen als Speicherblöcke vorteilhaft sein. In wiederum anderen Anwendungen können auch Brennstoffzellen als Speicherblöcke Verwendung finden.

Auch wenn die Integration der Energiespeichervorrichtung in einen Schaltschrank bereits eine gewisse Flexibilität und Umkonfigurierbarkeit ermöglicht, sind bisherige Lösungen doch nur begrenzt flexibel und nicht in ausreichendem Maße an den jeweiligen Anwendungsfall anpassbar. Insbesondere bei Verwendung für verschiedene Antriebssysteme, die hinsichtlich ihrer Leistungsklasse sehr weit voneinander entfernt liegen, ergeben sich bei bekannten Schaltschranklösungen Probleme hinsichtlich einer passend dimensionierten Kühlung und einem passend dimensionierten Schutz hinsichtlich der elektromagnetischen Verträglichkeit. Besitzt der Schaltschrank ein Kühlsystem, das für hohe Leistungsklassen ausreichend dimensioniert ist, erfolgt für Anwendungen mit nur einem Speicherblock und entsprechend kleiner Leistung eine zu starke Kühlung. Gleichzeitig kann eine starke elektromagnetische Dämmung des Schaltschranks unnötigen Bauraum verschwenden und zusätzliches Gewicht bedingen, das für Anwendungen mit kleineren elektromagnetischen Unverträglichkeiten überdimensioniert ist.

Zum anderen erfordern bekannte Schaltschranklösungen aber immer noch einen relativ hohen Umrüstaufwand, um die Steuerung und Leistungselektronik der Energiespeichervorrichtung an den jeweiligen Anwendungszweck anzupassen, auch wenn an sich nur begrenzte Variationen in dem Leistungsniveau zu kompensieren sind. So ist es beispielsweise immer noch relativ aufwendig, das Steuerungsmodul aus dem Schaltschrank auszubauen und durch ein anderes Steuerungsmodul zu ersetzen, welches dann wieder in entsprechender Weise mit den Speicherblöcken und anderen Komponenten zu verdrahten ist. Selbiges gilt für die Leistungselektronik, die gegebenenfalls mit der Steuervorrichtung zu einem Schaltschrank-Modul zusammengefasst ist.

Der vorliegenden Erfindung liegt daher die Aufgabe zugrunde, eine verbesserte Energiespeichervorrichtung der eingangs genannten Art zu schaffen, die Nachteile des Standes der Technik vermeidet und letzteren in vorteilhafter Weise weiterbildet. Insbesondere soll die Energiespeichervorrichtung entsprechend dem Bedarf ausreichend flexibel konfigurierbar sein und rasch ohne großen Aufwand umrüstbar sein, wenn die Energiespeichervorrichtung für einen anderen Anwendungszweck oder auch nur eine andere Betriebsart der angeschlossenen Antriebs- bzw. Arbeitsvorrichtung benötigt wird.

Erfindungsgemäß wird die genannte Aufgabe durch eine Energiespeichervorrichtung nach Anspruch 1 gelöst. Bevorzugte Ausgestaltungen der Erfindung sind Gegenstand der abhängigen Ansprüche.

Es wird also zunächst vorgeschlagen, die im Schaltschrankgehäuse verbaute Steuervorrichtung und die damit verbundenen Leistungselektronik-Bauteile selbst umkonfigurierbar bzw. variabel auszubilden, um eine Anpassung der Steuerung und Leistungselektronik an eine andere Betriebsart oder einen anderen Anwendungsfall zu ermöglichen, ohne hierfür das Steuerungs- und Leistungselektronikmodul austauschen und entsprechend Verdrahtungen bewerkstelligen zu müssen. Nach einem ersten Aspekt zeichnet sich die Energiespeichervorrichtung dadurch aus, dass der zumindest eine Stromsteller, über den die Leistungsanschlüsse der Energiespeichervorrichtung mit dem zumindest einen Speicherblock verbunden sind, skalierbar ausgebildet ist und in Abhängigkeit der verwendeten Anzahl von Speicherblöcken und deren Parallel- und/oder Serienverschaltung in unterschiedlichen Skalierstufen betrieben wird. Hierdurch kann ein Austauschen oder Umbauen des den Stromsteller enthaltenden Schaltschrank- bzw. Leistungselektronikmoduls vermieden werden. Wird beispielsweise das Leistungs- bzw. Spannungsniveau erhöht, indem ein zusätzlicher Speicherblock im Schaltschrank untergebracht wird und/oder von einer Serien- auf eine Parallelverschaltung übergegangen wird, kann der Stromsteller durch Umskalieren an das höhere zu verarbeitende Leistungsniveau angepasst werden. Beispielsweise kann der Stromsteller eine skalierbare Mehrphasenkonstruktion aufweisen und/oder mehrere Stellerelemente umfassen, die durch Parallelschalten eine Skalierbarkeit erlauben.

In vorteilhafter Weiterbildung der Erfindung kann der genannte Stromsteller einer DC/DC-Steller oder DC/DC-Wandler sein, über den der zumindest eine Speicherblock elektrische Energie an die Leistungsanschlüsse der Energiespeichervorrichtung gibt oder umgekehrt - bei Generatorbetrieb des angeschlossenen Antriebssystems - Energie in den Speicherblock geladen wird. Insbesondere kann hierbei ein bidirektrionaler DC/DC-Steller Verwendung finden, über den der zumindest eine Speicherblock sowohl Energie abgeben als auch geladen werden kann. Solche DC/DC-Wandler oder DC/DC-Steller bezeichnen eine elektrische Schaltung, die eine am Eingang zugeführte Gleichspannung in eine Gleichspannung mit höherem, niedrigerem oder invertiertem Spannungsniveau umsetzen kann und in der Lage ist, Energie vom hohen Spannungspegel in den niedrigen Spannungspegel zu transferieren, beispielsweise um den Energiespeicherblock zu laden, und ebenfalls in der anderen Richtung zu transferieren, das heißt auszuspeichern bzw. vom Speicherblock in den Gleichspannungskreis des Antriebssystems zu transferieren.

Je nach Speicherblock und Antriebssystem können aber auch andere Stromrichter oder -steller wie beispielsweise Gleichrichter, Wechselrichter, Frequenzrichter oder allgemein Umrichter Verwendung finden, wobei solche Stromrichter elektronische Bauteile wie etwas Dioden, Transistoren oder Thyristoren, aber auch Mosfets, IG-BTs oder IGCTs umfassen können.

Die vorgenannte Skalierbarkeit des zumindest einen Stromstellers kann dabei in Weiterbildung der Erfindung vorteilhafter Weise automatisiert oder zumindest halbautomatisiert erfolgen. Insbesondere kann eine Erfassungseinrichtung zum Erfassen des aktuellen Leistungsniveaus und/oder zum Erfassen der Anzahl der jeweils verwendeten Speicherblöcke und/oder deren Parallel- und/oder Serienschaltung vorgesehen sein, wobei eine Skaliervorrichtung den genannten Stromsteller in Abhängigkeit eines Signals der genannten Erfassungseinrichtung skalieren kann, beispielsweise durch Zu- oder Abschalten eines Elements oder einer Phase des genannten Stromstellers.

Um die Energiespeichervorrichtung nicht nur für Gleichspannungssysteme einsetzen zu können, kann zusätzlich zu dem zuvor genannten DC/DC-Steller ein vorzugsweise zu- und abschaltbarer Frequenzumrichter vorgesehen sein, sodass die Energiespeichervorrichtung wahlweise bei zugeschaltetem Frequenzumrichter für ein Wechselspannungsnetz und bei abgeschaltetem Frequenzumrichter für ein Gleichspannungsnetz gleichermaßen verwendbar ist.

Der genannte Frequenzumrichter kann in dem gleichen Schaltschrank wie die Speicherblöcke und die Steuervorrichtung bzw. Leistungselektronik untergebracht sein, alternativ aber auch in einem separaten Schaltschrank verbaut oder auch an anderer Stelle extern angeordnet sein.

Um den Schaltschrank in einfacher Weise an verschiedene Anwendungszwecke und Betriebsarten der jeweils angeschlossenen Arbeitsmaschine anpassen zu können, kann die Energiespeichervorrichtung vorteilhafter Weise verschieden ausgebildete Speicherblöcke umfassen, die gegeneinander austauschbar sind und vorteilhafter Weise in dieselben Aufnahmeplätze eingebaut werden können. Dies kann beispielsweise dadurch erreicht werden, dass die verschieden ausgebildeten Speicherblöcke gleiche Anschlussmaße oder zueinander kompatible Anschlussflächen besitzen, mittels derer sie in die Anschlussplätze des Schaltschranks einsetzbar sind. Sind die Anschlussplätze beispielsweise mit Einsteck- oder Einschubführungen versehen, können die Speicherblöcke unabhängig von ihrem Typ zu den Führungen passende Schubführungsflächen besitzen. Die Speicherblöcke müssen somit nicht in ihren gesamten Abmessungen und Außenmaßen zueinander identisch sein - was sie natürlich gleichwohl können - , sondern es ist ausreichend, wenn die für das Einsetzen in den jeweiligen Anschlussplatz relevanten Anschlussmaße passend sind.

Gleichwohl können die Speicherblöcke auch voneinander abweichende Anschlussmaße besitzen, wenn im Schaltschrank hierfür unterschiedliche Aufnahmeplätze vorgesehen sind.

Insbesondere können die verschiedenen Speicherblöcke zumindest zwei der folgenden drei Speicherblocktypen umfassen: Eine Kondensatorzelle, insbesondere in Form eines Doppelschichtkondensators, eine Batteriezelle und eine Brennstoffzelle.

Je nach Anwendungsfall können im Schaltschrank Speicherblöcke nur eines einzigen Typs untergebracht sein, beispielsweise nur Doppelschichtkondensatoren oder nur Batterien, wobei es vorteilhafter Weise möglich ist, je nach Anwendungsfall die Speicherblocktypen durch einander zu ersetzen.

Alternativ ist es in vorteilhafter Weiterbildung der Erfindung aber auch möglich, im selben Schaltschrank gleichzeitig verschiedene Speicherblocktypen unterzubringen, beispielsweise zumindest einen Doppelschichtkondensator und zumindest eine Batteriezelle. Durch eine hinsichtlich des Speicherblocktyps gemischte Anordnung von Speicherblöcken können deren Vorteile miteinander vereint werden. Insbesondere kann zumindest ein Doppelschichtkondensator im Schaltschrank untergebracht sein, um einen Leistungsspeicher zu haben, der rasch hohe elektrische Energiemengen aufnehmen und wieder abgeben kann, und weiterhin zumindest eine Batteriezelle als Speicherblock im Schaltschrank angeordnet werden, um einen Grund- oder Notfallbedarf abzudecken.

In vorteilhafter Weiterbildung der Erfindung umfasst die Energiespeichervorrichtung eine Kühlvorrichtung zum Kühlen der Speicherblöcke und gegebenenfalls auch zum Kühlen der Steuervorrichtung und/oder deren Leistungselektronik beispielsweise in Form des zuvor genannten DC/DC-Stellers oder eines anderen Stromstellers. Vorteilhafter Weise kann die genannte Kühlvorrichtung zumindest teilweise in das Schaltschrankgehäuse integriert sein, wobei die Kühlvorrichtung für Einsätze der Energiespeichervorrichtung in verschiedenen Leistungsklassen und/oder unterschiedliche Typen und Anzahlen von Speicherblöcken umkonfigurierbar ausgebildet sein kann oder verschieden ausgebildete Kühlmodule umfassen kann. Durch eine solche Umkonfigurierbarkeit der Kühlvorrichtung wird eine zu starke Kühlung vermieden, wenn die Energiespeichervorrichtung in nur geringen Leistungsklassen arbeitet oder Speicherblöcke verwendet, die temperaturunkritisch sind. Gleichzeitig wird eine ausreichende Kühlung für hitzeintensivere Anwendungen gewährleistet, ohne hierfür gleich den gesamten Schaltschrank ersetzen zu müssen.

Insbesondere kann die genannte Kühlvorrichtung ein Flüssigkühlmodul umfassen, das in dem Schaltschrankgehäuse Kühlmittelleitungen aufweisen kann, die entlang der genannten Aufnahmeplätze für die Speicherblöcke und/oder die Steuervorrichtung und/oder Leistungselektronik vorgesehen sein können, wobei die genannten Kühlmittelleitungen entlang oder auch durch die Aufnahmehalterungen der Aufnahmeplätze hindurch verlaufen können. Sind beispielsweise für die Speicherblöcke Schubfächer im Schaltschrankgehäuse vorgesehen, können das Schubfach begrenzende Wandungen, an denen die Speicherblöcke oder ein Steuerungs- und/oder Leistungselektronikmodul eingeschoben wird, mit solchen Kühlmittelleitungen versehen sein, um die Wärme aus den Speicherblöcken oder dem Leistungselektronikmodul herauszuziehen. Alternativ oder zusätzlich können aber auch Kühlmittelleitungen beispielsweise in Form von Kühlschlangen freiliegend angeordnet und vorteilhafter Weise unmittelbar benachbart zu den zu kühlenden Komponenten der Energiespeichervorrichtung angebracht sein.

Das sich an den warmen oder heißen Speichermodulen aufwärmende Kühlmittel wird über die Kühlmittelleitungen zu einem Rückkühler zirkuliert, der vorteilhafter Weise außerhalb des Schaltschrankgehäuses - beispielsweise auf dessen Dach oder Decke - angeordnet sein kann. Alternativ oder zusätzlich kann ein solcher Rückkühler auch in einem separaten Schaltschrank untergebracht sein, mit dem die Kühlmittelleitungen verbunden sind.

Alternativ oder zusätzlich zu einem solchen Flüssigkeitskühlmodul kann aber auch ein Luftkühlungsmodul vorgesehen sein, welches an und/oder zwischen den Aufnahmeplätzen Kühlrippen umfassen kann, durch die hindurch Kühlluft strömen kann. Um einen Kühlluftstrom zu erzeugen, kann zumindest ein Kühlluftgebläse vorgesehen sein, welches des Kühlluftstrom durch die zuvor genannten Kühlrippen hindurch blasen oder saugen kann. Vorteilhafter Weise kann an jeder Kühlrippengruppe, die zwischen Aufnahmeplätzen oder Speichermodulen vorgesehen ist, ein solches Kühlluftgebläse vorgesehen sein, um einen ausreichenden Kühlluftstrom zu erzeugen und jeden Aufnahmeplatz ausreichend zu kühlen, wobei die mehreren Kühlluftgebläse vorteilhafter Weise individuell schaltbar sein können, um nur die benötigten Aufnahmeplätze im Schaltschrankgehäuse wirklich zu kühlen. Bleiben beispielsweise ein oder zwei Aufnahmeplätze leer, weil nur eine geringe Anzahl an Speicherblöcken benötigt wird, oder bleiben für eine bestimmte Betriebsart einzelne Speicherblöcke abgeschaltet, können die entsprechenden Kühlluftgebläse ebenfalls abgeschaltet werden.

Alternativ oder zusätzlich zu solchen Flüssigkeits- und/oder Luftkühlungsmodulen kann aber auch ein zumindest Zweiphasenkühlmodul vorgesehen sein, welches ein zu kühlendes Element der Energiespeichervorrichtung durch Phasenwandlung des Kühlmediums kühlen kann. Insbesondere kann ein solches Zweiphasenkühlmodul zumindest ein Kühlmittelbehältnis aufweisen, in dem eine bereits bei niedrigen Temperaturen verdampfende Flüssigkeit aufgenommen ist, sodass die Flüssigkeit bei Wärmebeaufschlagung durch die Speicherblöcke oder ein Bauteil der Leistungselektronik oder ein anderes wärmeentwickelndes Bauteil verdampfen kann.

Vorteilhafter Weise kann ein solches Kühlmittelbehältnis unmittelbar an jedem oder zumindest einem der Aufnahmeplätze angeordnet sein und/oder auch direkt einem der dort anzuordnenden Speicherblöcke und/oder Leistungselektronikmodulen zugeordnet sein, um den jeweiligen Speicherblock oder das jeweilige Leistungselektronikbauteil effektiv zu kühlen.

Ein solches Zweiphasenkühlmodul kann vorteilhafter Weise eine Kühlflüssigkeit besitzen, die bei weniger als 70° oder auch weniger als 50° bereits verdampft.

In vorteilhafter Weiterbildung der Erfindung kann die Kühlvorrichtung ein Pumpen- und/oder Tankmodul umfassen, in dem vorteilhafterweise ein Speicherbehälter für die Kühlflüssigkeit und eine Umwälzpumpe zusammengefasst sein können, wobei vorteilhafterweise unabhängig hiervon das genannte Pumpen- und/oder Tankmodul hinsichtlich seiner Abmessungen und/oder Konturierung und/oder Anschlussmaße an die zuvor genannten Speicherblöcke angepasst sein kann derart, dass das genannte Pumpen- und/oder Tankmodul in einen der Aufnahmeplätze des Schaltschranks eingeschoben bzw. eingesetzt werden kann, der an sich zur Aufnahme eines Speicherblocks dienen kann. Insofern kann je nach Konfigurierung und Kühlbedarf an zumindest einem Aufnahmeplatz des Schaltschranks wahlweise ein Speicherblock oder das genannte Pumpen- und/oder Tankmodul eingesetzt werden. Vorteilhafterweise kann ein unterster Aufnahmeplatz des Schaltschranks zur Aufnahme des Pumpen- und/oder Tankmoduls vorgesehen bzw. das genannte Pumpen- und/oder Tankmodul daran angepasst sein.

Um den Schaltschrank auch hinsichtlich der elektromagnetischen Verträglichkeit leicht umkonfigurieren zu können, kann in dem Schaltschrank ein EMV-Filter zum Unterdrücken von elektromagnetischen Störungen vorzugsweise lösbar und austauschbar eingesetzt sein, wobei ein solcher EMV-Filter insbesondere auch in einem der Aufnahmeplätze des Schaltschranks eingesetzt werden kann.

Vorteilhafter Weise kann der genannte EMV-Filter hinsichtlich seiner Anschlussmaße den Anschlussmaßen eines Speicherblocks und/oder den Anschlussmaßen der Steuervorrichtung und/oder den Anschlussmaßen des Leistungselektronikmoduls entsprechend ausgebildet sein. Sind die Aufnahmeplätze beispielsweise nach Art eines Schubfachs ausgebildet und/oder mit einer Schubführung versehen, kann der EMV-Filter Schubführungsflächen besitzen, die mit den genannten Schubführungen der Aufnahmeplätze kompatibel sind und gegebenenfalls den Maßen der Schubführungsflächen der Speicherblöcke und/oder des Steuerungsmoduls und/oder des Leistungselektronikmoduls entsprechen, sodass der EMV-Filter und die genannten weiteren Komponenten wie Speicherblock, Steuerungsvorrichtung und Leistungselektronik variabel in dem Schaltschrank angeordnet werden können. Gegebenenfalls kann auch in einfacher Weise die Anzahl der EMV-Filter verändert werden, um wahlweise einen oder zwei oder auch mehrere EMV-Filter in dem Schaltschrank unterbringen zu können, ohne hierfür das Schaltschrankgehäuse per se umbauen zu müssen.

In Weiterbildung der Erfindung kann in dem Schaltschrankgehäuse weiterhin eine Trenneinrichtung zum automatischen Abtrennen der Speicherblöcke von dem Stromsteller in einem Fehlerfall vorgesehen sein, um zu verhindern, dass beispielsweise bei einem Kurzschluss des Stromstellers eine Beschädigung der Speicherblöcke erfolgt oder auch die unkontrollierte Abgabe von Energie durch die Speicherblöcke daran angeschlossene Komponenten der Antriebsvorrichtung beschädigen kann.

Beispielsweise kann eine solche Trenneinrichtung eine Pyrosicherung umfassen.

Um die Energiespeichervorrichtung in noch größerem Maße an verschiedene Anwendungsfälle anpassen und hinsichtlich ihres Leistungsniveaus weiter skalieren zu können, können auch mehrere Schaltschrankgehäuse vorgesehen sein, die jeweils in der genannten Weise in ihren Aufnahmeplätzen eine variable Anzahl von Speicherblöcken, eine Steuervorrichtung und ein Leistungselektronikmodul mit zumindest einem Stromsteller aufnehmen können. Vorteilhafter Weise können die mehreren Schaltschränke hierbei mit den Leistungsanschlüssen wahlweise parallel zueinander oder seriell miteinander verbunden und an das gemeinsam zu speisende bzw. zu unterstützende Antriebssystem angeschlossen werden.

Umfasst die Energiespeichervorrichtung mehrere Schaltschränke, in denen jeweils Speicherblöcke, eine Steuervorrichtung und eine Leistungselektronik untergebracht sein können, kann es vorteilhaft sein, wenn eine zumindest teilweise zentralisierte Kühlvorrichtung vorgesehen wird, insbesondere wenn die Kühlvorrichtung zumindest in einigen der Schaltschränke ein Flüssigkeitkühlmodul umfasst. Insbesondere können die durch die mehreren Schaltschränke verlaufenden Kühlmittelleitungen zu einem gemeinsamen Rückkühler geführt und mit diesem verbunden sein, um das Kühlmittel zentral rückzukühlen. Ein solcher Rückkühler kann in einem weiteren, separaten Schaltschrank untergebracht oder an anderer Stelle extern angeordnet sein.

Unabhängig vom Vorsehen nur eines Schaltschranks oder mehrerer Schaltschränke, kann es in Weiterbildung der Erfindung vorteilhaft sein, in zumindest einem Schaltschrank eine variabel konfigurierbare Steuervorrichtung vorzusehen, um die jeweilige Steuervorrichtung in einfacher Weise an verschiedene Anwendungszwecke und/oder verschiedene Betriebsarten anpassen zu können.

Insbesondere kann die Steuervorrichtung selbst einen modularen Aufbau besitzen und zumindest ein Controller-Board sowie ein damit verbindbares Adaptions-Board umfassen. Das genannte Controller-Board kann hierbei mit verschiedenen Steuermodulen versehen sein, um verschiedene Steuerungsfunktionen zu implementieren, wobei das Controller-Board zumindest Abgabe- und/oder Einspeisesteuermittel zum Ansteuern des Stromstellers für das Abgeben und/oder Einspeisen von Strom aus dem bzw. in den zumindest einen Speicherblock sowie Spannungsregel- und/oder Steuermittel zum Regeln und/oder Steuern der Ausgangsspannung der Energiespeichervorrichtung aufweisen kann.

Das genannte Adaptions-Board kann insbesondere mehrere Verbindungsanschlüsse für verschieden ausgebildete externe Systemsteuerungen, zumindest eine Kommunikationsschnittstelle zum Kommunizieren mit dem Controller-Board und zumindest einen Adaptions-Schaltkreis zum Anpassen und Übertragen von Signalen zwischen den genannten Verbindungsanschlüssen des Adaptions-Boards und dem Controller-Board aufweisen.

Durch die mehreren, voneinander verschieden ausgebildeten Verbindungsanschlüsse des Adaptions-Boards kann die in die Energiespeichervorrichtung integrierte Steuervorrichtung in einfacher Weise an verschieden ausgebildete, externe Systemsteuerungen angeschlossen werden.

Je nachdem, wie die externe Systemsteuerung ausgebildet ist, können über den jeweils passenden Verbindungsanschluss des Adaptions-Boards die von der externen Systemsteuerung benötigten oder bereitgestellten Signale, Datenformate und/oder Parameter empfangen oder übertragen bzw. bereitgestellt werden. Damit die von dem Controller-Board bereitgestellten Signale, Daten und/oder Parameter von der externen Systemsteuerung auch verwendet werden können oder umgekehrt von der externen Systemsteuerung bereitgestellte Signale, Daten, Befehle oder Parameter vom Controller-Board verwendet werden können, passt der zumindest eine Adaptions-Schaltkreis des Adaptions-Boards die genannten Signale, Daten, Befehle und/oder Parameter hinsichtlich ihres Formats und/oder Spannungslevels und/oder hinsichtlich ihrer Übertragungswege zum jeweiligen Verbindungsanschluss und/oder zur Kommunikationsschnittstelle des Adaptions-Boards an, sodass das Controller-Board mit verschieden ausgebildeten, übergeordneten externen Systemsteuerungen kommunizieren kann.

Vorteilhafterweise kann das Adaptions-Board mehrere Adaptions-Schaltkreise umfassen, von denen ein jeweils passender Schaltkreis die jeweils benötigten Signale, Daten und/oder Parameter von der/an die jeweilige externe Systemsteuerung adaptieren kann.

In Weiterbildung der Erfindung kann das genannte Adaptions-Board auch mehrere Sensoranschlüsse zum Anschließen an verschiedene Sensoren umfassen, die für die Systemsteuerung und/oder für die interne Steuervorrichtung benötigt werden. Insbesondere kann das Adaptions-Board mittels der genannten Sensoranschlüsse einerseits an energiespeichervorrichtungsinterne Sensoren, mittels derer die Energiespeichervorrichtung, insbesondere deren Speicherblock und/oder zumindest ein Betriebszustand am Stromrichter und/oder am internen Spannungskreis überwacht wird, angeschlossen werden. Alternativ oder zusätzlich kann das Adaptions-Board über die genannten Sensoranschlüsse an externe Sensoren angeschlossen werden, die zumindest einen Betriebszustand des anzuschließenden Antriebssystems oder dessen Leistungselektronik überwachen.

Beispielsweise können an die Sensoranschlüsse des Adaptions-Boards Kühlvorrichtungs-Sensoren zum Überwachen einer Kühlvorrichtung, beispielsweise ein Kühlmittelflussmengen- und/oder -massensensor und/oder ein Temperatursensor, und/oder ein Strom- und/oder Spannungssensor zum Überwachen eines Stromflusses und/oder einer Spannung im Spannungskreis des anzuschließenden Antriebssystems und/oder im internen Spannungskreis des Speicherblocks, und/oder ein Symmetriergrad-Sensor zum Überwachen der Symmetrierung mehrerer Speicherblöcke angeschlossen werden.

Der genannte zumindest eine Adaptions-Schaltkreis des Adaptions-Boards kann beispielsweise aus einer oder mehrerer Hardware-Komponenten in Form elektronischer Bausteine wie Halbleiterbausteinen bestehen, aber auch alternativ oder zusätzlich einen oder mehrere Software-Bausteine umfassen, die in einem Speicherbaustein gespeichert und in einem Prozessor verarbeitet werden können.

Das Adaptions-Board kann insbesondere auch mehrere solcher Hardware-Schaltkreise und/oder Software-Bausteine umfassen.

Unter Zuhilfenahme des genannten Adaptions-Boards kann ein an den Speicherblock und dessen Schaltkreis angepasstes Controller-Board Verwendung finden und trotzdem an verschiedene übergeordnete Systemsteuerungen angepasst und damit zusammen verwendet werden. Das genannte Adaptions-Board kann über eine oder mehrere Steckverbindungen lösbar mit dem genannten Controller-Board verbunden sein. Alternativ oder zusätzlich kann das Adaptions-Board aber auch fest mit dem Controller-Board verdrahtet sein.

Das genannte Controller-Board kann vorteilhafter Weise zumindest einen Mikrocontroller, zumindest einen FPGA-Baustein, das heißt ein Field-Programmable Gate Array, weiterhin Hardware-Schaltkreise und Steckverbinder für die Kontaktierung aufweisen und/oder aus den genannten Bausteinen bestehen. Die genannten Hardware-Schaltkreise des Controller-Boards können dabei elektronische Bausteine wie beispielsweise Halbleiterbausteine, Transistoren, Dioden oder andere aktive oder passive Bauelemente umfassen, wobei insbesondere auch integrierte Schaltkreise am Controller-Board vorgesehen sein können. Alternativ oder zusätzlich zu den genannten Hardware-Schaltkreisen kann das Controller-Board aber auch zumindest einen Software-Baustein umfassen, der in einem Speicherbaustein gespeichert ist und mit dem Mirkocontroller zusammenwirkt bzw. von diesem abgearbeitet wird.

In Weiterbildung der Erfindung kann die in die Energiespeichervorrichtung integrierte Steuervorrichtung weiterhin ein Kommunikations-Board umfassen, welches dazu vorgesehen ist, eine Feldbus-Kommunikation für die Steuervorrichtung zu ermöglichen, insbesondere mit signalgebenden und/oder mit signalverarbeitenden Bausteinen der Energiespeichervorrichtung wie beispielsweise Sensoren und/oder mit signalgebenden und/oder signalverarbeitenden Bausteinen der anzuschließenden Antriebsvorrichtung und/oder der externen Systemsteuerung wie beispielsweise an der Antriebsvorrichtung verbauten Sensoren.

Das genannte Communication-Board kann in vorteilhafter Weise Steckverbinder aufweisen und auf dem Controller-Board aufgesteckt sein.

In dem genannten Controller-Board kann in vorteilhafter Weise eine Fülle von Steuerungsfunktionen implementiert und/oder vorangelegt sein, die es der Steuervorrichtung ermöglichen, die Energiespeichervorrichtung für eine Fülle verschiedener Antriebsvorrichtungen und verschiedener externer Steuerungssysteme zu steuern und entsprechende Steuerungsfunktionen auszuführen, je nachdem welche Steuerungsfunktion von der Antriebsvorrichtung und/oder dem externen Steuerungssystem benötigt werden.

Insbesondere kann die Steuervorrichtung der Energiespeichervorrichtung Steuermittel zum Steuern des Betriebs des zumindest einen Speicherblocks umfassen, wobei die genannten Zustandssteuermittel für den Betrieb des Energiespeichers vorteilhafter Weise dazu konfiguriert sein können, eine automatische Vorladung eines internen Zwischenkreises und/oder ein automatisches Verbinden und Trennen zu einem externen Zwischenkreis des Antriebssystems und/oder ein automatisches Vorladen auf eine vorzugsweise parametrierbare Initialspannung auszuführen.

Alternativ oder zusätzlich kann die integrierte Steuerung Erfassungsmittel zum Erfassen verschiedener Sensoren umfassen, beispielsweise zumindest eines Spannungssensors und/oder zumindest eines Stromsensors und/oder zumindest eines Temperatursensors oder zumindest eines Durchflusssensors, mittels derer entsprechende Betriebsgrößen der Energiespeichervorrichtung und/oder des Antriebssystems gemessen werden können.

Alternativ oder zusätzlich kann die Steuervorrichtung der Energiespeichervorrichtung Leistungssteuermittel zum Erzeugen von Steuersignalen für die Leistungselektronik des Antriebssystems umfassen.

Alternativ oder zusätzlich kann die Steuervorrichtung einen Regler zum Regeln des Stroms im Speicherblock umfassen.

Alternativ oder zusätzlich kann die integrierte Steuervorrichtung Betriebssteuermittel zum Einstellen bzw. Steuern verschiedener Betriebsarten der Energiespeichervorrichtung umfassen, wobei die genannten Betriebssteuermittel insbesondere einen Regler zum Regeln einer Zwischenkreisspannung und/oder einen Regler zum Regeln einer Zwischenkreisspannung mit Sollwertfenster und/oder einen Regler zum Regeln eines Zwischenkreisstroms und/oder einen Regler zum Regeln einer Leistung und/oder einen Regler zum Regeln eines Ladungszustands und/oder Steuermittel zum aktiven Entladen des Speicherblocks umfassen können.

Alternativ oder zusätzlich kann die integrierte Steuervorrichtung einen Selbsttest-Baustein zum Selbsttesten der Leistungselektronik aufweisen.

Alternativ oder zusätzlich kann die integrierte Steuervorrichtung zumindest einen Begrenzer-Baustein umfassen, der dazu vorgesehen und ausgebildet ist, beim Erreichen von Speicher-Spannungsgrenzen und/oder beim Erreichen von Speicher-Stromgrenzen und/oder beim Erreichen von Zwischenkreis-Stromgrenzen und/oder beim Erreichen von Zwischen-Leistungsgrenzen und/oder beim Erreichen von Temperaturgrenzen zumindest eine charakteristische Stellgröße der Energiespeichervorrichtung und/oder der Antriebsvorrichtung zu begrenzen oder zu verändern, beispielsweise einen abgegebenen oder eingespeisten Strom und/oder ein Spannungsniveau zu begrenzen oder zu senken.

Ein solcher Begrenzer-Baustein kann vorteilhafter Weise parametrierbar ausgebildet sein, um die entsprechende Spannungsgrenze und/oder Stromgrenze und/oder Leistungsgrenze und/oder Temperaturgrenze einstellbar vorgeben zu können.

Alternativ oder zusätzlich kann die genannte Steuervorrichtung der Energiespeichervorrichtung zumindest einen Überwachungs-Baustein umfassen, der dazu ausgebildet ist, einen Überstrom in der Energiespeichervorrichtung und/oder eine Überspannung in einem Zwischenkreis und/oder eine Spannung in der Energiespeichervorrichtung und/oder eine Spannung in dem zumindest einen Speicherblock, und/oder eine Übertemperatur beispielsweise im Kühlwasser einer Kühlvorrichtung und/oder in dem zumindest einen Speicherblock und/oder in einem Innenraum der Energiespeichervorrichtung und/oder an zumindest einer Drossel, und/oder einem Zustand zumindest eines Relais und/oder eine Kühlvorrichtung beispielsweise hinsichtlich Kühlmitteldurchfluss und/oder eines Kühlaggregatszustands, und/oder eine Leistungselektronik und/oder einen Speicherzustand und/oder eine Symmetrierungsfunktion der Speicherblöcke zu überwachen. Alternativ oder zusätzlich können auch Überwachungsmittel zum Überwachen der Restlebensdauer der Energiespeichervorrichtung und/oder des zumindest einen Speicherblocks vorgesehen sein, wobei solche Überwachungsmittel die genannte Restlebensdauer berechnen und/oder schätzen können.

Alternativ oder zusätzlich kann das zuvor genannte Kommunikations-Board und/oder das Adaptions-Board einen Feldbus-Kommunikations-Baustein für eine Feldbus-Kommunikation zu externen Steuerungssystem aufweisen, wobei der Feldbus-Kommunikations-Baustein beispielsweise dazu vorgesehen sein kann, eine Betriebsart vorzugeben und/oder ein Starten bzw. Stoppen der Antriebsvorrichtung vorzugeben und/oder einen Sollwert für eine jeweilige Betriebsart vorzugeben und/oder veränderbare Limits während eines Betriebs vorzugeben und/oder einen Vorsteuerwert für eine Regelung und/oder Betriebsart vorzugeben und/oder einen aktuellen Status des Energiespeichers auszulesen und/oder aktuelle Betriebsdaten auszulesen und bereitzustellen.

Alternativ oder zusätzlich kann die genannte Steuervorrichtung der Energiespeichervorrichtung einen Statistik-Baustein zum Bestimmen und/oder Speichern von statistischen Daten umfassen, beispielsweise einer Zeitverteilung einer Speichertemperatur und/oder einer Zeitverteilung einer Leistung und/oder einer Zeitverteilung eines Stroms in der Energiespeichervorrichtung und/oder einer Zeitverteilung einer Spannung in der Energiespeichervorrichtung.

Alternativ oder zusätzlich kann die Steuervorrichtung eine Master-/Slave-Steuereinrichtung zum Betreiben mehrerer Speicherblöcke in einem Master-/Slave-Modus umfassen, wobei eine solche Master-/Slave-Steuereinrichtung vorteilhafter Weise Kommunikationsmittel, die eine Kommunikation mehrerer Energiespeichereinheiten untereinander vorzugsweise über einen CAN-BUS ermöglichen, und/oder Synchronisationsmittel zum Synchronisieren der Spannung der mehreren parallelgeschalteten Energiespeichereinheiten und/oder Aufteil-Steuermittel zum gleichmäßigen Aufteilen des Stroms in den parallelgeschalteten Energierspeichereinheiten umfassen kann.

Alternativ oder zusätzlich kann die genannte Steuervorrichtung Betriebsdaten-Übertragungsmittel zum Übertragen von Betriebsdaten der zumindest einen Energiespeichervorrichtung an einen zentralen Server und/oder eine Cloud umfassen.

In vorteilhafter Weiterbildung der Erfindung kann die interne Steuervorrichtung der Energiespeichervorrichtung, insbesondere zumindest eines der vorgenannten Steuermittel, parametrierbar ausgebildet sein, um über entsprechende Vorgabe von Parametern die genannten Funktionalitäten verändern zu können. Ein Parametrierungs-Baustein kann vorteilhafter Weise über eine USB-Schnittstelle und/oder eine Profinet-Schnittstelle mit einem externen oder internen Parametrierungs-Gerät, beispielsweise einem PC-Programm OPAL kommunizieren, um die gewünschte Parametrierung vorzunehmen.

Vorteilhafterweise kann mittels des genannten Parametrierungs-Bausteins zumindest eine der folgenden Funktionalitäten parametriert bzw. angepasst werden:
- zumindest ein Kommunikationsparameter,
- zumindest ein Parameter zur Leistungselektronik wie beispielsweise der maximale Strom, eine minimale und/oder maximale Spannung, zumindest ein Sensor, zumindest eine Schaltzeit und/oder zumindest eine Schaltfrequenz,
- zumindest ein Betriebsmodus, beispielsweise ein Steuerungs-Modus über einen Feldbus und/oder ein Master-/Slave-Modus und/oder ein Fehlerreaktions-Modus,
- zumindest eine Überwachungsfunktion wie beispielsweise die Vorgabe eines Grenzwerts für eine Kühlvorrichtung und/oder eine Symmetrierungsfunktion und/oder eine Spannung, und/oder zumindest ein Grenzwert für Strom und Leistung der Energiespeichervorrichtung und/oder der Antriebsvorrichtung,
- Nenndaten der Energiespeichervorrichtung wie beispielsweise Nennkapazität und/oder Nennstrom und/oder Induktivität,
- eine Einstellung zumindest eines Reglers.

Die Erfindung wird nachfolgend anhand bevorzugter Ausführungsbeispiele und zugehöriger Zeichnungen näher erläutert. In den Zeichnungen zeigen:

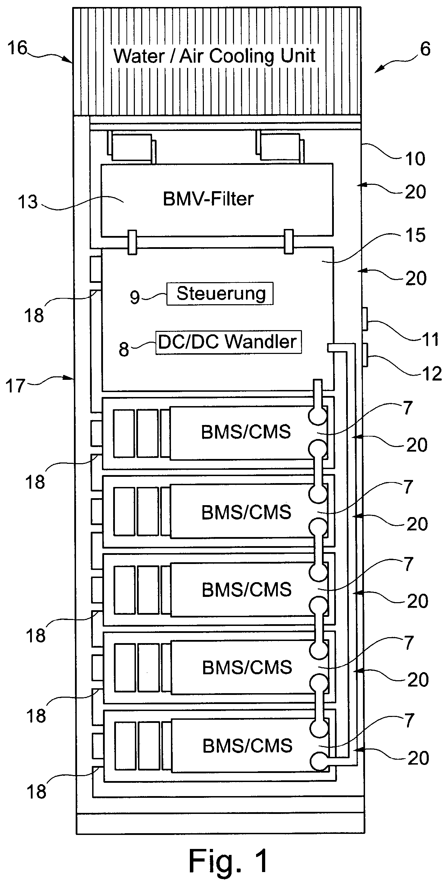

Fig. 1: eine schematische Darstellung einer Energiespeichervorrichtung mit einem Schaltschrankgehäuse, in dem mehrere Speicherblöcke, ein Steuerungs- und Leistungselektronikmodul und ein EMV-Filter untergebracht sind, wobei eine Kühlvorrichtung mit einem Flüssigkeitskühlmodul zum Kühlen der Speicherblöcke und gegebenenfalls auch des Leistungselektronikmoduls vorgesehen ist,

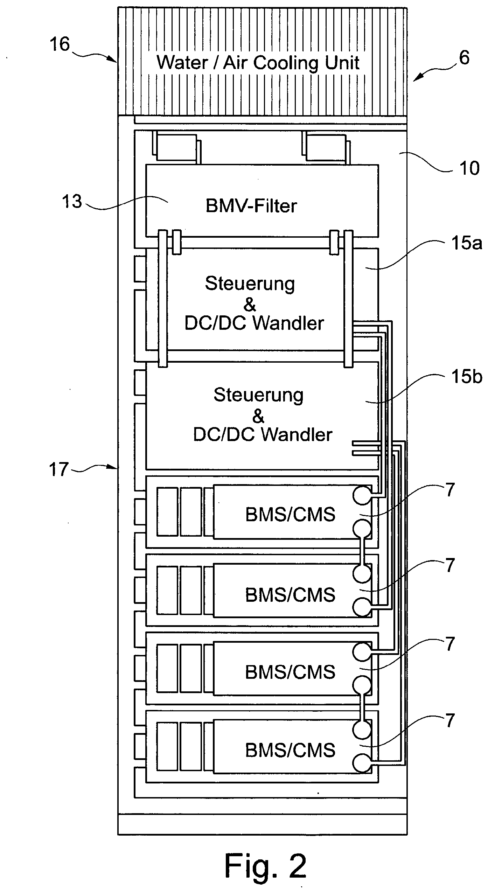

Fig. 2: eine Energiespeichervorrichtung mit einem Schaltschrankgehäuse ähnlich Fig. 1, wobei zwei separate Steuerungs- und Leistungselektronikmodule vorgesehen und mit jeweils einer eigenen Gruppe von Speicherblöcken verbunden sind, um an einen separaten Vierpol- oder einen gemeinsamen Zweipolzwischenkreis angeschlossen werden zu können,

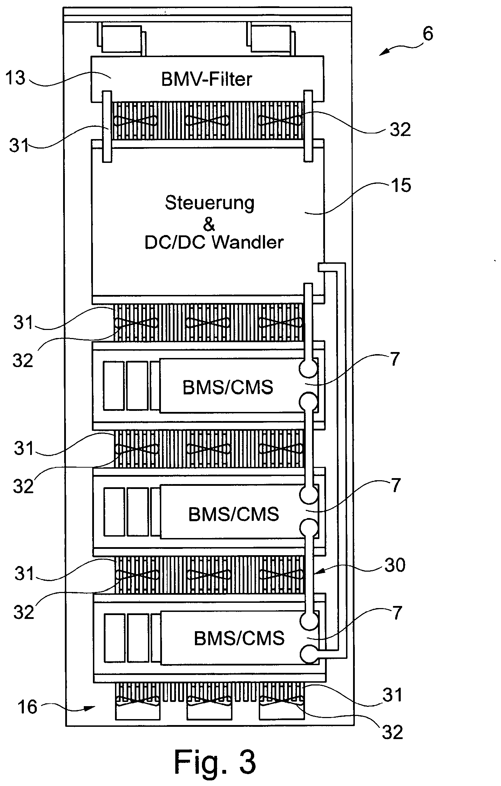

Fig. 3: eine Energiespeichervorrichtung mit einem Schaltschrankgehäuse ähnlich den vorhergehenden Figuren, wobei die Kühlvorrichtung ein Kühlluftmodul mit Kühlrippen zwischen den Speicherblöcken und den Steuerungs-, Leistungselektronik- und Filtermodulen mit Kühlluftgebläsen aufweist,

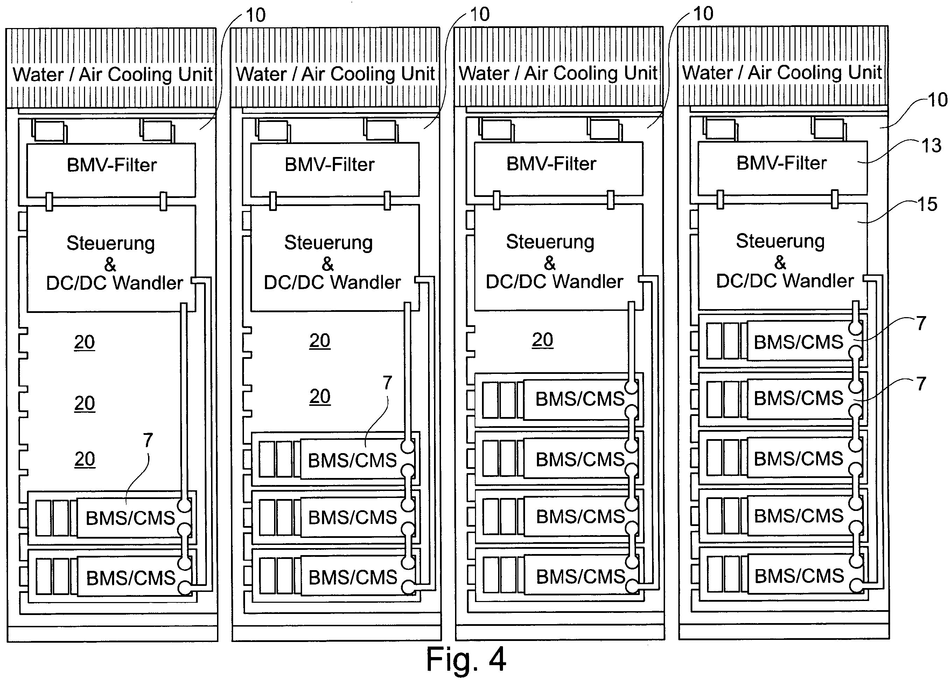

Fig. 4: eine Anordnung von mehreren Schaltschränken, die durch die Anordnung unterschiedlich vieler Speicherblöcken in den Schaltschrankgehäusen unterschiedliche skaliert sind,

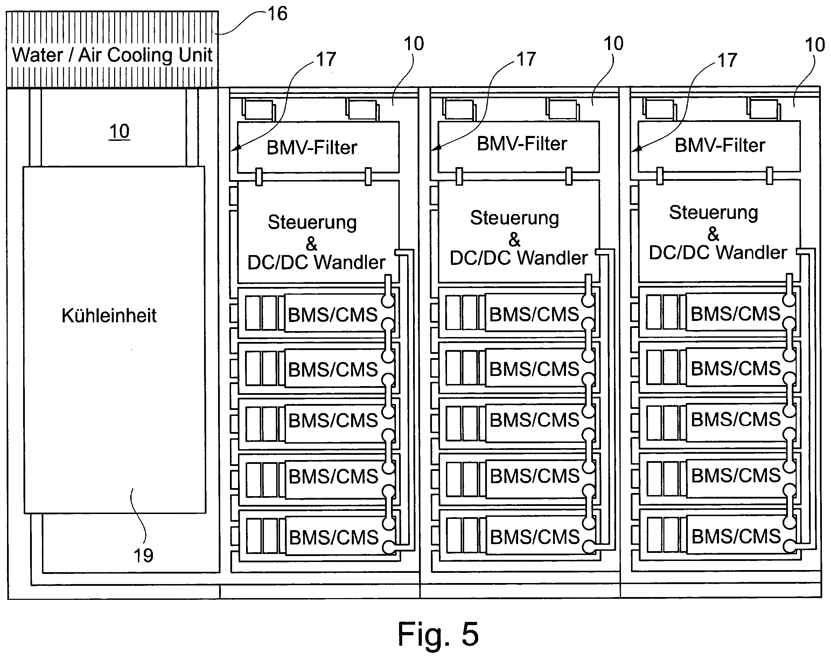

Fig. 5: eine Anordnung mehrerer Schaltschränken mit jeweils darin aufgenommenen Speicherblöcken, einem Steuerungs- und Leistungselektronikmodul und einem Filtermodul, wobei in den Schaltschränken vorgesehene Flüssigkeitskühlmodule an einen Rückkühler angeschlossen sind, der in einem weiteren, separaten Schaltschrank untergebracht ist,

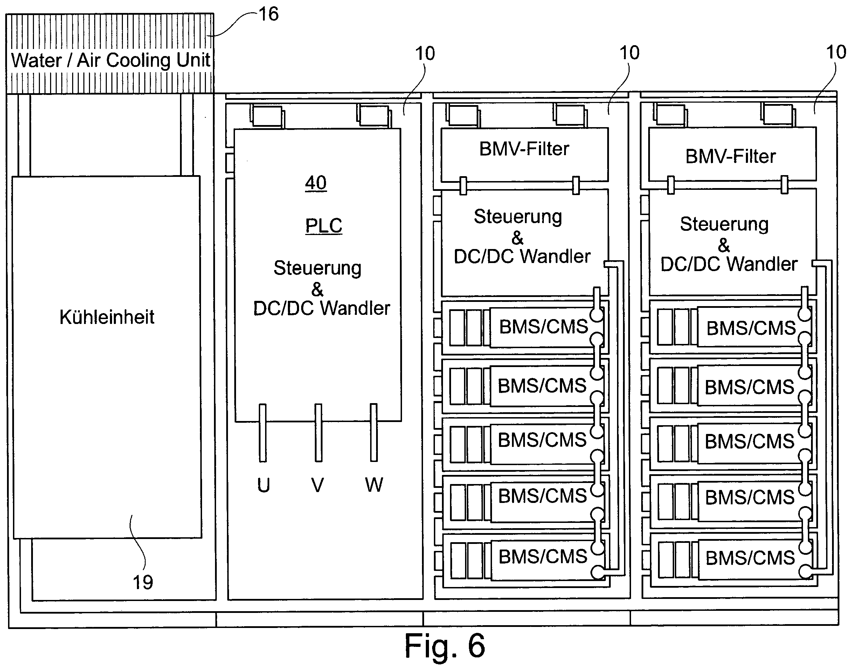

Fig. 6: eine Anordnung mehrerer Schaltschränke ähnlich Fig. 5, wobei mehrere Schaltschränke jeweils Speicherblöcke, ein Steuerungs- und Leistungselektronikmodul sowie ein Filtermodul aufweisen und mit ihren Flüssigkeitskühlmodulen an einen separaten, gemeinsamen Rückkühler in einem separaten Schaltschrank angeschlossen sind, wobei zusätzlich in einem weiteren Schaltschrank ein AC/DC-Wandler untergebracht ist, um die Energiespeichervorrichtung an ein Wechselspannungsnetz anschließen zu können.

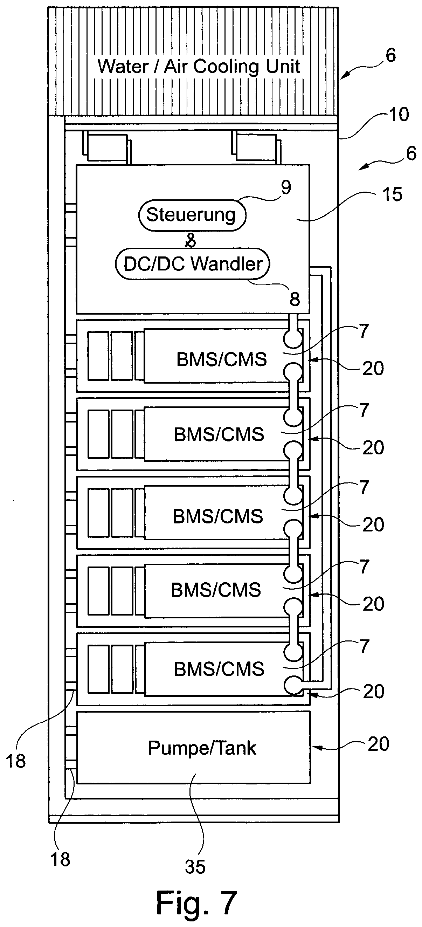

Fig. 7: eine schematische Darstellung einer Energiespeichervorrichtung ähnlich Fig. 1 nach einer weiteren vorteilhaften Ausführung der Erfindung, wobei im Vergleich zur Ausführung der Fig. 1 der EMV-Filter weggelassen und ein Pumpen- und Tankmodul in den Schaltschrank eingesetzt ist.

Wie Fig. 1 zeigt, umfasst die Energiespeichervorrichtung 6 ein Schaltschrankgehäuse 10, das im Wesentlichen als Kubus oder Quader ausgebildet sein kann und vorzugsweise an seiner Vorderseite eine in den Zeichnungen nicht eigens dargestellte, vorzugsweise aufschwenkbare Tür umfassen kann, um in das Innere des Schaltschranks und die dort angeordneten Komponenten Zugriff zu haben. Von der genannten Tür abgesehen, wird der Schaltschrank von Schaltschrankwänden einschließlich Boden und Deckel begrenzt.

In dem Schaltschrankgehäuse 10 sind eine Vielzahl von Aufnahmeplätzen 20 vorgesehen, die übereinander und/oder nebeneinander im Inneren des Schaltschranks vorgesehen sein können. Die genannten Aufnahmeplätze 20 können alle oder gruppenweise gleichgroß oder auch unterschiedlich groß dimensioniert sein.

Um Komponenten in einfacher Weise in die Aufnahmeplätze 20 einsetzen zu können, können die Aufnahmeplätze 20 jeweils Schiebeführungen und/oder Steckkonturen aufweisen, die beispielsweise liegend näherungsweise parallel zur Tiefenrichtung des Schaltschranks ausgerichtet sein können, um ein einfaches Einsetzen der Komponenten zu ermöglichen.

Wie Fig. 1 zeigt, können eine Mehrzahl von Speicherblöcken 7 in dem Schaltschrankgehäuse 10 aufgenommen werden, die beispielsweise als Kondensatorzelle, insbesondere Doppelschichtkondensator, aber auch als Batteriezelle oder Brennstoffzelle ausgebildet sein können. Dabei können Speicherblöcke 7 nur eines Typs, oder auch Speicherblöcke verschiedenen Typs, beispielsweise eine Mischung aus Doppelschichtkondensatorblöcken und Batterieblöcken im Schaltschrank angeordnet sein.

Zusätzlich zu den Speicherblöcken 7 ist in einem Schaltschrankgehäuse 10 an einem der Aufnahmeplätze 20 vorteilhafter Weise ein Steuerungs- und Leistungselektronikmodul 15 untergebracht, welches eine elektronische Steuervorrichtung 9 aufweisen kann, welches beispielsweise einen Mikrocontroller, verschiedene Schaltkreise, eine Sensorik und gegebenenfalls einen oder mehrere Softwarespeicherbausteine umfassen kann.

Weiterhin kann das Steuerungsmodul 15 zumindest einen Stromsteller, insbesondere in Form eines DC/DC-Stellers 8 umfassen, über den elektrische Energie aus den Speicherblöcken 7 auf Leistungsanschlüsse 11, 12 der Energiespeichervorrichtung 6 gegeben werden kann. Der genannte DC/DC-Steller 8 kann vorteilhafter Weise bidirektional ausgebildet sein, um über die Leistungsanschlüsse 11, 12 rückgespeisten Strom in die Speicherblöcke 7 rückspeisen zu können.

Die Steuerungsvorrichtung 9 und der genannte Stromsteller können gegebenenfalls aber auch in separaten Modulen untergebracht sein, die in separate Aufnahmeplätze 20 des Schaltschrankgehäuses 10 einsetzbar sein können.

In der gezeichneten Ausführung der Fig. 1 sind die Speicherblöcke 7 in Serie geschaltet und mit dem Steuerungsmodul 15 verbunden. Alternativ kann die Anordnung aber auch umkonfiguriert werden und die Leistungsspeicherblöcke 7 auch parallel geschaltet an das Steuerungsmodul 15 angeschlossen werden.

Weiterhin kann in dem Schaltschrankgehäuse 10 ein EMV-Filter 13 untergebracht sein, um elektromagnetische Störungen zu unterdrücken bzw. zu filtern. Der genannte EMV-Filter 13 kann vorteilhafter Weise ebenfalls in einem der Aufnahmeplätze 20 des Schaltschrankgehäuses 10 eingesetzt sein und hinsichtlich seiner Anschlussmaße hierfür entsprechend ausgebildet sein.

Wie Fig. 1 zeigt, kann die Energiespeichervorrichtung 6 weiterhin eine Kühlvorrichtung 16 umfassen, die ein Flüssigkeitskühlmodul 17 aufweisen kann, in dem eine Kühlflüssigkeit wie beispielsweise Wasser zirkuliert. Dabei können Kühlmittelleitungen 18 insbesondere entlang der Aufnahmeplätze 20 vorgesehen sein, beispielsweise auch durch die Wandungen der Aufnahmeführung hindurchgehen, und/oder in Form von Kühlschlangen an den Hitze entwickelnden Speicherblöcken 7 und/oder dem Steuerungs- und Leistungsmodul 15 entlanggeführt sein. Alternativ oder zusätzlich können die einzelnen Aufnahmeplätze 20 auch mit Kühlleitungsanschlüssen versehen sein, um interne Kühlmittelleitungen beispielsweise in den Speicherblöcken anschließen zu können, sodass die Kühlflüssigkeit auch durch die Speicherblöcke und/oder durch die Steuerungs- und Leistungselektronikmodule hindurchströmen kann.

Das Flüssigkeitskühlmodul 17 kann weiterhin einen Rückkühler 19 umfassen, der vorteilhafter Weise außerhalb des Schaltschrankgehäuses 10 angeordnet, beispielsweise auf dessen Dach platziert sein kann, um die von den Speicherblöcken 7 und/oder dem Steuerungs- und Leistungsmodul 15 erwärmte Kühlflüssigkeit wieder rückzukühlen und die Wärme an die Umgebung abzugeben.

Wie Fig. 2 zeigt, können auch mehrere Steuerungs- und/oder Leistungselektronikmodule 15a und 15b in dem Schaltschrankgehäuse 10 verbaut sein, wobei eine Untergruppe der Speicherblöcke 7 mit dem einen Steuerungs- und/oder Leistungselektronikmodul 15 verbunden und eine andere Untergruppe der Speicherblöcke 7 mit dem anderen Steuerungs- und/oder Leistungselektronikmodul 15b verbunden ist. Hierdurch können trotz Anordnung in einem gemeinsamen Schaltschrankgehäuse 10 zwei autarke Speichersysteme vorgesehen werden, welche jeweils an einen separaten Vierpol oder auch an einen gemeinsamen Zweipolgleichspannungszwischenkreis angeschlossen werden können.

Wie Fig. 3 zeigt, kann alternativ oder zusätzlich zu einem Flüssigkeitkühlmodul die Kühlvorrichtung 16 auch ein Luftkühlmodul 30 aufweisen, um die Wärme entwickelnden Komponenten der Energiespeichervorrichtung 6 mit Kühlluft zu kühlen. Ein solches Luftkühlmodul 30 kann insbesondere an den oder zwischen den Aufnahmeplätzen 20 bzw. an den bzw. zwischen den Speicherblöcken 7 und/oder dem Steuerungs- und/oder Leistungselektronikmodul 15 und gegebenenfalls auch dem EMV-Filter 13 eine Anordnung von Kühlrippen 31 aufweisen, die stoffschlüssig an die Wandungen der Aufnahmeplätze, gegebenenfalls aber auch direkt an die Speicherblöcke 7 und/oder das Steuerungs- und/oder Leistungselektronikmodul 15 und gegebenenfalls das den EMV-Filter 13 angeschlossen sein können, um die Wärme aus den Komponenten effektiv in die Kühlrippen gelangen zu lassen und von diesen durch die große Fläche der Kühlrippen effizient an die Kühlluft abzugeben.

Zum Zirkulieren der Kühlluft ist vorteilhafter Weise zumindest ein Kühlluftgebläse 32 vorgesehen, wobei vorteilhafter Weise jeder der Kühlrippenanordnungen zumindest ein eigenes Kühlluftgebläse 32 zugeordnet sein kann, vgl. Fig. 3.

Vorteilhafter Weise kann das zumindest eine Kühlluftgebläse 32 Umgebungsluft durch Einlässe am Schaltschrankgehäuse 10, beispielsweise der Schaltschranktür ansaugen und die erhitzte Luft vorteilhafter Weise in einem oberen Bereich des Schaltschrankgehäuses 10 wieder an die Umgebung abgeben.

Wie Fig. 4 zeigt, können die Schaltschränke beliebig skaliert werden, indem die Anzahl der im Schaltschrankgehäuse 10 untergebrachten Speicherblöcke 7 variiert wird, wobei gegebenenfalls auch einige Aufnahmeplätze 20 leer bleiben können. Gegebenenfalls kann aber auch ein Speicherblock oder können mehrere Speicherblöcke 7 abgetrennt bzw. nicht angeschlossen werden, ansonsten aber im Schaltschrankgehäuse 10 verbleiben.

Alternativ oder zusätzlich kann eine Skalierung der Schaltschränke auch dadurch erreicht werden, dass einzelne Speicherblöcke 7 durch leistungsstärkere oder leistungsschwächere Speicherblöcke ersetzt werden, um verschiedenen Leistungsniveaus gerecht zu werden.

Vorteilhafter Weise ist der DC/DC-Steller 8 des Steuerungs- und Leistungselektronikmoduls 15 hierbei skalierbar ausgebildet, um den verschiedenen Leistungskonfigurationen gleichermaßen gerecht werden zu können.

Die mehreren Schaltschränke mit den darin jeweils aufgenommenen Speicherblöcken können mit ihren Leistungsanschlüssen parallelgeschaltet oder auch in Serie geschaltet an eine jeweilige Arbeitsmaschine, beispielsweise ein Antriebssystem angeschlossen werden, um die Energieversorgungseinrichtung in größerem Maßstab skalieren zu können, indem nicht nur innerhalb eines Schaltschranks die Anzahl oder der Typ der Speicherblöcke variiert wird, sondern die jeweils benötigte Anzahl von Schaltschränken parallel oder in Serie geschaltet wird.

Wie Fig. 5 zeigt, können bei Verwendung mehrerer Schaltschränke die darin vorgesehenen Flüssigkeitskühlmodule 17 an eine gemeinsame, extern angeordnete Kühleinheit angeschlossen werden. Insbesondere kann ein gemeinsamer, separater Rückkühler 19 vorgesehen werden, der in einem weiteren, separaten Schaltschrankgehäuse untergebracht sein kann und an die Kühlmittelleitungen 18 in den anderen Schaltschrankgehäusen 10 angebunden ist, um das darin zirkulierende Kühlfluid rückzukühlen. Durch einen solchen gemeinsamen Rückkühler 19 können separate Rückkühler an jedem der Schaltschrankgehäuse 10 eingespart werden. Dabei kann gegebenenfalls die Anzahl der Schaltschränke, die mit ihren Kühlmittelleitungen 18 an den gemeinsamen Rückkühler 19 angeschlossen sind, variiert werden.

Wie Fig. 6 zeigt, kann ein weiteres Schaltschrankgehäuse 10 auch vorgesehen werden, um ein übergeordnetes Steuerungsmodul 40 unterzubringen, das beispielsweise eine Systemsteuerung für ein anzuschließendes Antriebssystem sein kann oder zumindest einen Teil hiervon bilden kann. Alternativ oder zusätzlich kann in einem separaten Schaltschrankgehäuse 10 auch ein zusätzliches Leistungselektronikmodul untergebracht werden, das mit dem zuvor genannten Steuerungsmodul 40 zusammengefasst sein kann, aber auch separat ausgebildet sein kann. Ein solches zusätzliches Leistungselektronikmodul kann insbesondere einen AC/DC-Wandler umfassen und/oder einen Frequenzumrichter besitzen, um die Speicherblöcke 7 auch an ein Wechselspannungsnetz bzw. eine Wechselspannungsmaschine anschließen zu können.

Wie Figur 7 zeigt, kann der EMV-Filter 13 auch weggelassen werden bzw. die Energiespeichervorrichtung 6 auch derart konfiguriert bzw. umkonfiguriert werden, dass im Schaltschrankgehäuse 10 auf einen solchen EMV-Filter 13 verzichtet wird. Dies schafft zusätzlichen Platz im Schaltschrankgehäuse 10 beispielsweise für einen weiteren Speicherblock und kann insbesondere dann eine sinnvolle Konfiguration sein, wenn es auf die elektromagnetische Verträglichkeit weniger ankommt.

Wie Figur 7 weiterhin zeigt, kann in vorteilhafter Weiterbildung der Erfindung die Kühlvorrichtung auch eine Pumpen- und Tankeinheit 35 umfassen, in deren Speicherbehältnis Kühlflüssigkeit gespeichert werden kann und deren Pumpe zum Umwälzen der Kühlflüssigkeit dienen kann. Die genannte Pumpen- und Tankeinheit 35 kann hinsichtlich ihrer Abmessungen und Anschlussmaße vorteilhafterweise entsprechend einem der Speicherblöcke 7 entsprechend gestaltet sein und/oder an einen der Aufnahmeplätze 20 angepasst sein, sodass die genannte Pumpen- und Tankeinheit 35 in einen der Aufnahmeplätze 20 eingesetzt werden kann. Wie zuvor für die Speicherblöcke 7 beschrieben, kann die genannte Pumpen- und Tankeinheit 35 Schiebeführungs- und/oder Steckkonturen aufweisen, um in entsprechende Schiebeführungen und/oder Steckkonturen des jeweiligen Aufnahmeplatzes 20 eingesetzt werden zu können.

Ähnlich wie bei der Ausführung nach Figur 7 kann der EMV-Filter 13 auch bei den vorhergehenden Ausführungsformen nach den Figuren 1 bis 6 weggelassen werden und/oder das in Figur 7 gezeigte Tank- und Pumpenmodul in einer der anderen Ausführungsbeispiele im Schaltschrankgehäuse 10 entsprechend untergebracht werden.

## Patentansprüche

1. Energiespeichervorrichtung mit einem Schaltschrankgehäuse (10), in dem mehrere Aufnahmeplätze (20) vorgesehen sind, in denen zumindest eine Steuervorrichtung (9) und eine variable Anzahl von Speicherblöcken (7) austauschbar aufgenommen sind, wobei die Speicherblöcke (7) wahlweise seriell oder parallel zueinander verschaltbar und über einen Stromsteller (8) mit Leistungsanschlüssen (11, 12) verbunden sind, **dadurch gekennzeichnet dass** der Stromsteller (8) skalierbar ausgebildet ist und in Abhängigkeit der verwendeten Anzahl an Speicherblöcken (7) und deren Parallel- und/oder Serienschaltung in unterschiedlichen Skalierstufen betrieben wird.

2. Energiespeichervorrichtung nach dem vorhergehenden Anspruch, wobei eine Erfassungseinrichtung zum Erfassen der verwendeten Anzahl an Speicherblöcken und/oder deren Parallel- und/oder Serienschaltung vorgesehen ist und eine Skaliervorrichtung den genannten Stromsteller (8) in Abhängigkeit eines Signals der Erfassungseinrichtung automatisch skaliert.

3. Energiespeichervorrichtung nach einem der vorhergehenden Ansprüche, wobei als Stromsteller (8) zumindest ein DC/DC-Steller vorgesehen ist, wobei ein zu- und abschaltbarer Frequenzumrichter und/oder ein- und abschaltbarer AC/DC-Wandler (41) vorgesehen ist, sodass die Energiespeichervorrichtung wahlweise bei zugeschaltetem Frequenzumrichter und/oder AC/DC-Wandler (41) für Wechselspannungssysteme und bei abgeschaltetem Frequenzumrichter und/oder AC/DC-Wandler (41) für Gleichstromsysteme verwendbar ist.

4. Energiespeichervorrichtung nach einem der vorhergehenden Ansprüche, wobei verschieden ausgebildete Speicherblöcke (7) in den Aufnahmeplätzen (20) des Schaltschrankgehäuses (10) aufnehmbar und gegeneinander austauschbar sind, wobei die Speicherblöcke (7) zumindest zwei der folgenden Speicherblocktypen umfassen: Kondensatorzelle, Batteriezelle, Brennstoffzelle.

5. Energiespeichervorrichtung nach dem vorhergehenden Anspruch, wobei in dem Schaltschrankgehäuse (10) gleichzeitig ein Speicherblock (7) mit einem Doppelschichtkondensator und ein Speicherblock (7) mit einer Batteriezelle untergebracht sind.

6. Energiespeichervorrichtung nach einem der vorhergehenden Ansprüche, wobei eine Kühlvorrichtung (16) zum Kühlen der Speicherblöcke (7) und/oder der Steuerungsvorrichtung (9) und/oder des Stromstellers (8) vorgesehen und zumindest teilweise in dem Schaltschrankgehäuse (10) untergebracht ist, wobei die Kühlvorrichtung (16) für verschiedene Leistungskonfigurationen der Speicherblöcke (7) und/oder für verschiedene Speicherblöcke umkonfigurierbare Kühlmodule umfasst.

7. Energiespeichervorrichtung nach dem vorhergehenden Anspruch, wobei die Kühlvorrichtung (16) zumindest ein Flüssigkeitskühlmodul (17) umfasst, das in dem Schaltschrankgehäuse (10) Kühlmittelleitungen (18) aufweist, die an den Aufnahmeplätzen (20) entlang und/oder durch Aufnahmehalterungen zum Halten der Speicherblöcke (7) hindurch verlaufen.

8. Energiespeichervorrichtung nach einem der beiden vorhergehenden Ansprüche, wobei die Kühlvorrichtung (16) zumindest ein Luftkühlungsmodul (30) umfasst, wobei an und/oder zwischen den Aufnahmeplätzen und/oder an den Speicherblöcken (7) Kühlrippen (31) sowie zumindest ein Kühlluftgebläse (32) zum Erzeugen eines Kühlluftstroms durch die Kühlrippen (31) hindurch vorgesehen ist.

9. Energiespeichervorrichtung nach einem der drei vorhergehenden Ansprüche, wobei die Kühlvorrichtung (16) zumindest ein Zweiphasen-Kühlmodul umfasst, das zumindest an einem der Aufnahmeplätze (20) und/oder zumindest einem der Speicherblöcke (7) ein Kühlmittelbehältnis aufweist, das mit einem bei niedrigen Temperaturen verdampfenden Flüssigkeit befüllt ist.

10. Energiespeichervorrichtung nach dem vorhergehenden Anspruch, wobei die Kühlflüssigkeit einen Siedepunkt von weniger als 70°C oder weniger als 50°C oder als weniger als 35°C besitzt.

11. Energiespeichervorrichtung nach einem der vorhergehenden Ansprüche, wobei die Kühlvorrichtung (16) eine Pumpen- und/oder Tankeinheit (35) umfasst, die hinsichtlich Form und Abmessungen derart an die Speicherblöcke (7) angepasst ist, dass die genannte Pumpen- und/oder Tankeinheit (35) in einen für einen Speicherblock (7) vorgesehenen Aufnahmeplatz (20) im Schaltschrankgehäuse (10) einsetzbar ist.

12. Energiespeichervorrichtung nach einem der vorhergehenden Ansprüche, wobei zumindest ein EMV-Filter (13) zum Unterdrücken oder Reduzieren von elektromagnetischen Störungen in dem Schaltschrankgehäuse (10) untergebracht ist, insbesondere in einen der Aufnahmeplätze (20) eingesetzt ist.

13. Energiespeichervorrichtung nach einem der vorhergehenden Ansprüche, wobei in dem Schaltschrankgehäuse (10) eine Trenneinrichtung zum automatischen Abtrennen der Speicherblöcke (7) von dem Stromsteller (8) im Fehlerfall vorgesehen ist.

14. Energiespeichervorrichtung nach einem der vorhergehenden Ansprüche, wobei mehrere Schaltschrankgehäuse (10) vorgesehen sind, die jeweils in Aufnahmeplätzen (20) aufgenommene Speicherblöcke (7) umfassen, wobei die mehreren Schaltschrankgehäuse (10) mit den Leistungsanschlüssen (11, 12) der darin aufgenommenen Speicherblöcke (7) wahlweise parallel- oder seriellgeschaltet sind.

15. Energiespeichervorrichtung nach dem vorhergehenden Anspruch, wobei zumindest zwei der mehreren Schaltschrankgehäuse (10) jeweils ein Flüssigkeitskühlmodul (17) umfassen und mit Kühlmittelleitungen (18) an einen gemeinsamen Rückkühler (19) angeschlossen sind, der in einem weiteren, separaten Schaltschrank untergebracht ist.

## Claims

1. Energy storage device having a switching cabinet housing (10) in which a plurality of reception spaces (20) are provided, in which at least one control device (9) and a variable number of storage blocks (7) are replaceably received, wherein the storage blocks (7) are selectively interconnected in series or in parallel and are connected to power connections (11, 12) via a current controller (8), **characterized in that** the current controller (8) is configured to be scalable and is operated in different scaling stages depending on the number of storage blocks (7) used and on their parallel and/or serial connection.

2. Energy storage device in accordance with the preceding claim, wherein a detection device is provided for the detection of the number of storage blocks used and/or of their parallel and/or serial connection, and a scaling device automatically scales said current controller (8) in dependence on a signal of the detection device.

3. Energy storage device in accordance with one of the preceding claims, wherein at least one DC/DC controller is provided as the current controller (8), with a frequency converter that can be switched on and off and/or an AC/DC converter (41) that can be switched on and off being provided so that the energy storage device can selectively be used with a switched on frequency converter and/or AC/DC converter (41) for AC voltage systems and with a switched off frequency converter and/or AC/DC converter (41) for DC current systems.

4. Energy storage device in accordance with one of the preceding claims, wherein differently configured storage blocks (7) are receivable and mutually exchangeable in the reception spaces (20) of the switchgear cabinet housing (10), with the storage blocks (7) comprising at least two of the following storage block types: a capacitor cell, a battery cell, a fuel cell.

5. Energy storage device in accordance with the preceding claim, wherein a storage block (7) having a double layer capacitor and a storage block (7) having a battery cell are simultaneously accommodated in the switchgear cabinet housing (10).

6. Energy storage device in accordance with one of the preceding claims, wherein a cooling device (16) is provided for cooling the storage blocks (7) and/or the control device (9) and/or the current controller (8) and is at least partly accommodated in the switchgear cabinet housing (10), with the cooling device (16) comprising reconfigurable cooling modules for different performance configurations of the storage blocks (7) and/or for different storage blocks.

7. Energy storage device in accordance with the preceding claim, wherein the cooling device (16) comprises at least one liquid cooling module (17) that has coolant lines (18) in the switchgear cabinet housing (10) that extend along the reception spaces (20) and/or through reception holders for holding the storage blocks (7).

8. Energy storage device in accordance with one of the two preceding claims, wherein the cooling device (16) comprises at least one air cooling module (30), with cooling ribs (31) and at least one cooling air fan (32) for generating a cooling air flow through the cooling ribs (31) being provided at and/or between the reception spaces and/or at the storage blocks (7).

9. Energy storage device in accordance with one of the three preceding claims, wherein the cooling device (16) comprises at least one two-phase cooling module that has a coolant container at at least one of the reception spaces (20) and/or at least one of the storage blocks (7), said coolant container being filled with liquid that evaporates at low temperatures.

10. Energy storage device in accordance with the preceding claim, wherein the cooling liquid has a boiling point of less than 70°C or less than 50°C or less than 35°C.

11. Energy storage device in accordance with one of the preceding claims, wherein the cooling device (16) comprises a pump and/or tank unit (35) that is adapted with respect to shape and dimensions to the storage blocks (7) such that said pump and/or tank unit (35) can be inserted into a reception space (20) in the switchgear cabinet housing (10) provided for a storage block (7).

12. Energy storage device in accordance with one of the preceding claims, wherein at least one EMC filter (13) is accommodated in the switchgear cabinet housing (10), in particular in one of the reception spaces (20), for suppressing or reducing electromagnetic interference.

13. Energy storage device in accordance with one of the preceding claims, wherein a disconnection device is provided in the switchgear cabinet housing (10) for the automatic disconnection of the storage blocks (7) from the current controller (8) in an error case.

14. Energy storage device in accordance with one of the preceding claims, wherein a plurality of switchgear cabinet housings (10) are provided that each comprise storage blocks (7) received in reception spaces (20), with the plurality of switchgear cabinet housing (10) being selectively connected in parallel or series to the power connections (11, 12) of the storage blocks (7) received therein.

15. Energy storage device in accordance with the preceding claim, wherein at least two of the plurality of switchgear cabinet housings (10) each comprise a liquid cooling module (17) and are connected to coolant lines (19) at a common heat exchanger (19) that is accommodated in a further separate switchgear cabinet.

## Revendications

1. Dispositif de stockage d'énergie avec un boîtier d'armoire électrique (10), dans lequel sont prévus plusieurs emplacements de réception (20), dans lesquels sont reçus de manière interchangeable au moins un dispositif de commande (9) et un nombre variable de blocs de stockage (7), les blocs de stockage (7) pouvant être connectés au choix en série ou en parallèle les uns par rapport aux autres et étant reliés par l'intermédiaire d'un régulateur de courant (8) à des raccordements de puissance (11, 12), **caractérisé en ce que** le régulateur de courant (8) est conçu sous forme pouvant être mis à l'échelle et est exploité à différents niveaux d'échelle en fonction du nombre de blocs de stockage (7) utilisés et de leur connexion en parallèle et/ou en série.

2. Dispositif de stockage d'énergie selon la revendication précédente, dans lequel un appareil de détection est prévu pour détecter le nombre utilisé de blocs de stockage et/ou leur connexion en parallèle et/ou en série, et un dispositif de mise à l'échelle met automatiquement à l'échelle ledit régulateur de courant (8) en fonction d'un signal de l'appareil de détection.

3. Dispositif de stockage d'énergie selon l'une quelconque des revendications précédentes, dans lequel il est prévu en tant que régulateur de courant (8) au moins un régulateur DC/DC, il étant prévu un convertisseur de fréquence pouvant être connecté et déconnecté et/ou un convertisseur AC/DC (41) pouvant être connecté et déconnecté, de telle sorte que le dispositif de stockage d'énergie peut être utilisé au choix pour des systèmes de tension alternative lorsque le convertisseur de fréquence et/ou le convertisseur AC/DC (41) sont connectés et pour des systèmes de courant continu lorsque le convertisseur de fréquence et/ou le convertisseur AC/DC (41) sont déconnectés.

4. Dispositif de stockage d'énergie selon l'une quelconque des revendications précédentes, dans lequel des blocs de stockage (7) conçus différemment peuvent être reçus dans les emplacements de réception (20) du boîtier d'armoire électrique (10) et peuvent être échangés les uns avec les autres, les blocs de stockage (7) comprenant au moins deux des types de blocs de stockage suivants : cellule de condensateur, cellule de batterie, pile à combustible.

5. Dispositif de stockage d'énergie selon la revendication précédente, dans lequel un bloc de stockage (7) avec un condensateur à double couche et un bloc de stockage (7) avec une cellule de batterie sont simultanément disposés dans le boîtier d'armoire électrique (10).

6. Dispositif de stockage d'énergie selon l'une quelconque des revendications précédentes, dans lequel un dispositif de refroidissement (16) est prévu pour refroidir les blocs de stockage (7) et/ou le dispositif de commande (9) et/ou le régulateur de courant (8) et est disposé au moins partiellement dans le boîtier d'armoire électrique (10), le dispositif de refroidissement (16) comprenant des modules de refroidissement reconfigurables pour différentes configurations de puissance des blocs de stockage (7) et/ou pour différents blocs de stockage.

7. Dispositif de stockage d'énergie selon la revendication précédente, dans lequel le dispositif de refroidissement (16) comprend au moins un module de refroidissement par liquide (17) qui présente des conduites de fluide de refroidissement (18) dans le boîtier d'armoire électrique (10), qui s'étendent le long des emplacements de réception (20) et/ou à travers des supports de réception pour maintenir les blocs de stockage (7).

8. Dispositif de stockage d'énergie selon l'une quelconque des deux revendications précédentes, dans lequel le dispositif de refroidissement (16) comprend au moins un module de refroidissement par air (30), des ailettes de refroidissement (31) étant prévues sur et/ou entre les emplacements de réception et/ou sur les blocs de stockage (7), ainsi qu'au moins un ventilateur d'air de refroidissement (32) pour générer un courant d'air de refroidissement à travers les ailettes de refroidissement (31).

9. Dispositif de stockage d'énergie selon l'une quelconque des trois revendications précédentes, dans lequel le dispositif de refroidissement (16) comprend au moins un module de refroidissement à deux phases qui présente, au moins à l'un des emplacements de réception (20) et/ou au moins à l'un des blocs de stockage (7), un réservoir de fluide de refroidissement qui est rempli d'un liquide s'évaporant à basse température.

10. Dispositif de stockage d'énergie selon la revendication précédente, dans lequel le liquide de refroidissement possède un point d'ébullition inférieur à 70 °C ou inférieur à 50 °C ou inférieur à 35 °C.

11. Dispositif de stockage d'énergie selon l'une quelconque des revendications précédentes, dans lequel le dispositif de refroidissement (16) comprend une unité de pompe et/ou de réservoir (35) dont la forme et les dimensions sont adaptées aux blocs de stockage (7) de telle sorte que ladite unité de pompe et/ou de réservoir (35) peut être insérée dans un emplacement de réception (20) prévu pour un bloc de stockage (7) dans le boîtier d'armoire électrique (10).

12. Dispositif de stockage d'énergie selon l'une quelconque des revendications précédentes, dans lequel au moins un filtre CEM (13) destiné à supprimer ou à réduire les perturbations électromagnétiques est disposé dans le boîtier d'armoire électrique (10), notamment inséré dans l'un des emplacements de réception (20).

13. Dispositif de stockage d'énergie selon l'une quelconque des revendications précédentes, dans lequel un appareil de séparation est prévu dans le boîtier d'armoire électrique (10) pour séparer automatiquement les blocs de stockage (7) du régulateur de courant (8) en cas de défaut.

14. Dispositif de stockage d'énergie selon l'une quelconque des revendications précédentes, dans lequel il est prévu plusieurs boîtiers d'armoire électrique (10) qui comprennent chacun des blocs de stockage (7) reçus dans des emplacements de réception (20), les plusieurs boîtiers d'armoire électrique (10) étant connectés au choix en parallèle ou en série avec les raccordements de puissance (11, 12) des blocs de stockage (7) qui y sont reçus.

15. Dispositif de stockage d'énergie selon la revendication précédente, dans lequel au moins deux des plusieurs boîtiers d'armoire électrique (10) comprennent chacun un module de refroidissement par liquide (17) et sont raccordés par des conduites de fluide de refroidissement (18) à un refroidisseur arrière commun (19) qui est disposé dans une autre armoire électrique séparée.
